# EUROPEAN PATENT APPLICATION

(11) **EP 4 507 086 A1**
(43) Date of publication of application: **12.02.2025**
(21) Application number: 23190711.4
(22) Date of filing: 10.08.2023
(51) Int. Cl.: H01M 50/204, B60R 21/013, H01M 50/249, H01M 50/284

(54) **BATTERY SYSTEM WITH IMPACT DETECTION**

(71) Applicant: Samsung SDI Co., Ltd., Yongin-si, Gyeonggi-do 17084 (KR)
(72) Inventor: Ipek, Eymen, 8020 Graz (AT)
(74) Representative: Gulde & Partner

(57) **Abstract**

The present disclosure refers to a battery system (100) and a method of detecting an impact on a battery system. The battery system (100) includes a plurality of battery cells (10) accommodated in a housing (20). The battery system (100) includes an impact detection circuit (30). The impact detection circuit (30) includes an electrical resistor circuit (40) supported by a plate member (22) adjacent the plurality of battery cells (10) including a plurality of electrical brittle conductors (42) electrically connected in parallel to each other. Each electrical brittle conductor (42) is configured to break in response to an impact causing a deformation of the electrical brittle conductor (42). A voltage source (50) is connected to the electrical resistor circuit (40) and configured to apply a voltage to the electrical resistor circuit (40). Furthermore, a detection unit (60) is configured to determine an electrical resistance (R, R') of the electrical resistor circuit (40) and/or an electrical current (I, I') flowing through the electrical resistor circuit (40). Further, the detection unit (60) is configured to detect an impact on the battery system (100) based on determining a resistance increase (ΔR) and/or an electrical current drop (ΔI) due to breaking of at least one of the electrical brittle conductors (42)

## Description

### Field of the Disclosure

The present disclosure relates to a battery system including an impact detection circuit and a method for detecting an impact on a battery system. Furthermore, a vehicle is provided including the battery system.

### Technological Background

Recently, vehicles for transportation of goods and peoples have been developed that use electric power as a source for motion. Such an electric vehicle is an automobile that is propelled by an electric motor, using energy stored in rechargeable batteries. An electric vehicle may be solely powered by batteries or may be a form of hybrid vehicle powered by for example a gasoline generator or a hydrogen fuel power cell. A hybrid vehicle may include a combination of an electric motor and conventional combustion engine. Generally, an electric-vehicle battery, EVB, or traction battery is a battery used to power the propulsion of battery electric vehicles, BEVs. Electric-vehicle batteries differ from starting, lighting, and ignition batteries in that they are designed to provide power for sustained periods of time. A rechargeable (or secondary) battery differs from a primary battery in that it is designed to be repeatedly charged and discharged, while the latter is designed to provide only an irreversible conversion of chemical to electrical energy. Low-capacity rechargeable batteries are used as power supplies for small electronic devices, such as cellular phones, notebook computers and camcorders, while high-capacity rechargeable batteries are used as power supplies for electric and hybrid vehicles and the like.

Rechargeable batteries may be used as a battery module formed of a plurality of unit battery cells coupled to each other in series and/or in parallel so as to provide a high density such as for motor driving of a hybrid vehicle. For example, the battery module may be formed by interconnecting the electrode terminals of the plurality of unit battery cells in an arrangement or configuration depending on a desired amount of power and in order to realize a high-power rechargeable battery.

A battery pack is a set of any number of (usually identical) battery modules. The battery modules may be configured in a series, parallel or a mixture of both to deliver the desired voltage, capacity, and/or power density. Components of a battery pack include the individual battery modules, and the interconnects, which provide electrical conductivity between the battery modules.

A battery system may also include a battery management system (BMS), which is any suitable electronic system that is configured to manage the rechargeable battery cell, battery module and battery pack, such as by protecting the batteries from operating outside their safe operating area, monitoring their states, calculating secondary data, reporting that data, controlling its environment, authenticating it and/or balancing it. For example, the BMS may monitor the state of the battery cell as represented by voltage (e.g., a total voltage of the battery pack or battery modules, and/or voltages of individual battery cells), temperature (e.g., an average temperature of the battery pack or battery modules, coolant intake temperature, coolant output temperature, or temperatures of individual battery cells), coolant flow (such as flow rate, cooling liquid pressure), and current. The BMS may be centralized such that a single controller is connected to the battery cells through a multitude of wires. In other example, the BMS may be also distributed, with a BMS board is installed at each battery cell, with just a single communication cable between the battery cell and a controller.

The BMS may prevent operation outside the battery's safe operating area by including an internal switch (such as a relay or solid-state device) which is opened if the battery is operated outside its safe operating area, requesting the devices to which the battery cell is connected to reduce or even terminate using the battery, and actively controlling the environment, such as through heaters, fans, air conditioning or liquid cooling. In case of an abnormal operation state, a battery pack shall usually be disconnected from a load connected to a terminal of the battery pack. Therefore, battery systems further include a battery disconnect unit (BDU) that is electrically connected between the battery module and battery system terminals.

Battery systems according to the prior art, despite any modular structure, include a battery housing that serves as enclosure to seal the battery system against the environment and provides structural protection of the battery system's components. Housed battery systems are usually mounted as a whole into their application environment, e.g. an electric vehicle.

Battery systems, for example, automatic battery systems, include battery cells that can be hazardous in case of fire. For example, passengers may need to be warned before any danger occurs outside of the battery.

A battery system located under the vehicle can be affected by road conditions like rocks and sloid parts from the road or can be affected by obstacles like bollard. An impact on the battery system caused by these obstacles should to be detected since such an impact could lead to malfunction of at least parts of the battery system. Therefore, impact detection is important for safely operating the battery system and/or the vehicle using it.

Existing impact detection for battery systems however require expensive and complex parts. It is known from the prior art that strain gage detectors can be used to detect an impact on a battery system. These strain gage detectors as disclosed for example in US 2022/0029215 A1 may have at least one conductor track to sense a mechanical stress which causing a bending of the conductor which is translated into an electrical signal. This change is then evaluated by way of a control unit. The above solution requires a multitude of strain gage detectors to perform local sensing at the various positions of the battery system to detect an impact.

It is desirable to provide a battery system that requires less resources for safely and reliably detect an impact on the battery system according to various information degrees to safely operate a battery system and a vehicle including the same.

### Summary of Invention

The invention is defined by the appended claims. The description that follows is subjected to this limitation. Any disclosure lying outside the scope of said claims is only intended for illustrative as well as comparative purposes.

According to one aspect of the present disclosure, a battery system includes a plurality of battery cells accommodated in a housing. The battery system further includes an impact detection circuit. The impact detection circuit includes an electrical resistor circuit supported by a plate member adjacent the plurality of battery cells and including a plurality of electrical brittle conductors electrically connected in parallel to each other. Each electrical brittle conductor is configured to break in response to an impact causing a deformation of the electrical brittle conductor. The battery system further includes a voltage source connected to the electrical resistor circuit and configured to apply a voltage to the electrical resistor circuit. The detection unit is configured to detect an impact on the battery system based on sensing an event of breaking of at least one among the plurality of electrical brittle conductors.

According to another aspect of the present disclosure, a method for detecting an impact on a battery system includes the steps of providing a battery system including a plurality of battery cells accommodated in a housing. The method includes providing an impact detection circuit. The impact detection circuit includes an electrical resistor circuit supported by a plate member adjacent the plurality of battery cells, disposed on a plate member or integrated therein, including a plurality of electrical brittle conductors electrically connected in parallel to each other, wherein each electrical brittle conductor is configured to break in response to an impact causing a deformation of the electrical brittle conductor. The method includes to apply, by a voltage source, a voltage to the resistor circuit plurality of electrical brittle conductors. The method further includes to determine, by a detection unit, an electrical resistance of the electrical resistor circuit and/or an electrical current flowing through the electrical resistor circuit. The method my further include detecting an impact on the battery system based on determining a resistance increase and/or an electrical current drop due to breaking of at least one of the electrical brittle conductors.

Yet another aspect of the present disclosure refers to a vehicle including the battery system.

Further aspects of the present disclosure could be learned from the dependent claims or the following description.

### Brief Description of the Drawings

Features will become apparent to those of ordinary skill in the art by describing in detail exemplary embodiments with reference to the attached drawings in which:
- Fig. 1: illustrates a schematic view of a battery system according to an embodiment including an illustration of a state in which no impact has occurred (a) and a state in which an impact has occurred (b),
- Fig. 2: illustrates a schematic cross section of a part of a battery system,
- Fig. 3: illustrates an impact detection circuit according to an embodiment illustrating a state in which no impact has occurred (a) and a state in which an impact has occurred (b),
- Fig. 4: illustrates a resistance increase and electrical current drop circuit caused by breaking of at least one electrical brittle conductor,
- Fig. 5: illustrates a method of detecting an impact on the battery system and schematically discloses the battery system, and
- Fig. 6: illustrates a vehicle including a battery system according to an embodiment.

### Detailed Description of the invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. The present disclosure, however, may be embodied in various different forms, and should not be construed as being limited to only the illustrated embodiments herein.

Accordingly, processes, elements, and techniques that are not considered necessary to those having ordinary skill in the art for a complete understanding of the aspects and features of the present disclosure may not be described. In the drawings, the relative sizes of elements, layers, and regions may be exaggerated for clarity.

As used herein, the term "and/or" includes any and all combinations of one or more of the associated listed items. Further, the use of "may" when describing embodiments of the present disclosure refers to "one or more embodiments of the present disclosure." In the following description of embodiments of the present disclosure, the terms of a singular form may include plural forms unless the context clearly indicates otherwise.

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present disclosure. Further, if the term "substantially" is used in combination with a feature that could be expressed using a numeric value, the term "substantially" denotes a range of +/- 5% of the value centered on the value.

It will be further understood that the terms "include," "comprise," "including," or "comprising" specify a property, a region, a fixed number, a step, a process, an element, a component, and a combination thereof but do not exclude other properties, regions, fixed numbers, steps, processes, elements, components, and combinations thereof.

Herein, the terms "upper" and "lower" are defined according to the z-axis. For example, the upper cover is positioned at the upper part of the z-axis, whereas the lower cover is positioned at the lower part thereof. In the drawings, the sizes of elements may be exaggerated for clarity. For example, in the drawings, the size or thickness of each element may be arbitrarily shown for illustrative purposes, and thus the embodiments of the present disclosure should not be construed as being limited thereto.

The electronic or electric devices and/or any other relevant devices or components according to embodiments of the present disclosure described herein may be implemented utilizing any suitable hardware, firmware (e.g. an application-specific integrated circuit), software, or a combination of software, firmware, and hardware. Further, the various components of these devices may be implemented on a flexible printed circuit film, a tape carrier package (TCP), a printed circuit board (PCB), or formed on one substrate. The electrical connections or interconnections described herein may be realized by wires or conducting elements, e.g. on a PCB or another kind of circuit carrier. The conducting elements may comprise metallization, e.g. surface metallization and/or pins, and/or may comprise conductive polymers or ceramics. Further electrical energy might be transmitted via wireless connections, e.g. using electromagnetic radiation and/or light.

Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like.

### General Concept

According to one aspect of the present disclosure, a battery system is provided which includes plurality of battery cells accommodated in a housing. The battery system further includes an impact detection circuit. The impact detection circuit includes an electrical resistor circuit supported by a plate member adjacent the plurality of battery cells. The electrical resistor circuit includes a plurality of electrical brittle conductors or ribbons electrically connected in parallel to each other. Each of the electrical brittle conductor is configured to break in response to an impact causing a deformation of the electrical brittle conductor. The battery system further includes a voltage source connected to the electrical resistor circuit. The voltage source applies a voltage to the electrical resistor circuit. The detection unit is configured to determine an electrical resistance of the electrical resistor circuit and/or an electrical current flowing through the electrical resistor circuit. The detection unit is configured to detect an impact on the battery system based on determining a resistance increase and/or an electrical current drop due to breaking of at least one of the electrical brittle conductors.

An electrical brittle conductor may be long and thin so that it can break in response to a deformation. The detection unit may be a signal conditioning circuit in other words. An electrical brittle conductor may be an electrically conductive brittle ribbon. The electrical brittle conductor may be a coating-free conductor so that the electrical brittle conductor can break in case of deformation. The electrical brittle conductor may be made of aluminum. In other embodiments, the electrical brittle conductor may be made of an alloy material, for example, a carbon metal alloy. The detection unit may include a control unit. Further, the detection unit may include a sensing unit or measurement unit to indirectly or directly determine the resistance of the electrical resistor circuit and/or the current flowing through the electrical resistor circuit. The electrical resistor circuit is supported by a plate member adjacent the plurality of battery cells. For example, a location of the electrical resistor circuit may be at a bottom portion of the housing. Specifically, the plate member may be positioned below the plurality of battery cells. Thus, the impact detection circuit coming from below the housing. For example, the plate member supporting the electrical resistor circuit may be disposed below the housing and separate therefrom. The electrical resistor circuit may be disposed on a plate member of the housing. Further, plate member due to the resistors thereon has certain resistance in the installation.

The battery system has the advantage that an impact on the battery system can be accurately detected without requiring much resources since the electrically conductive brittle conductor breaks in response to a deformation. Thus, when a deformation of an electrical brittle conductor caused by an impact has occurred, for example when being deformed above a threshold, the electric brittle conductor breaks. Due to the breakage of the at least one electric brittle conductor, an electrical current cannot flow through this electric brittle conductor anymore. Thus, the breakage of at least one brittle conductor changes the resistance of the (entire) resistor circuit.

Therefore, to detect an impact on the battery system, the present disclosure requires only one detection unit which monitors the electric current though the resistor circuitry and/or the resistance of the resistor circuit. Thus, resources for impact detection can be reduced since it is sufficient to monitor the collective current and/or resistor of the resistor circuit instead of monitoring each of the conductive brittle conductors. In addition, the brittle resistors being in the plate may give the plate robustness for installation. Thus, a very cost-efficient, fast and accurate detection is achieved. For example, the detection unit may determine an impact when the current drop and/or the resistance increase is above a threshold value, respectively, to detect a breakage of the brittle conductor. Further warning signals may be outputted in response to impact detection or a battery may be disconnected in response to an impact detection.

According to one aspect of the present disclosure, the electrical resistor circuit further includes a plurality of electrical resistors, wherein each electrical brittle conductor is electrically connected in series with at least one electrical resistor. In other words, the electrical brittle conductor and a corresponding at least one electrical resistor form one electrical path within the electrical resistor circuit. The resistance of the electrical brittle conductor is relatively small. Therefore, in a case where only electrical brittle conductors are used, a resistance change and a current change may be small and difficult to detect. Therefore, in the case where a resistor is connected in series with one electrical brittle conductor, in case of breakage, the resistance increase of the resistor circuit and the current drop are increased compared to when electrical resistors are not included. Thus, since the change in electrical resistance is increased in the case of where a resistor is connected in series with one electrical brittle conductor, it is easier to the detect an impact on the battery system. The relatively small resistance of the electrical brittle conductor comes from the breaking property and/or least partly arises from oxide layers formed in the manufacturing. Therefore, by including the resistors, it is easier for a detection unit to determine the breakage of at least one brittle conductor. Thus, a common detection unit may be used. The resistance value of the electrical resistors may be for example between 0.1 kΩ and 10 kΩ or between 0.5 kΩ and 5 kΩ or may be between 0.8 kΩ and 1.2 kΩ or 1 kΩ. The resistance value may be significantly higher than the resistance value of the electrical brittle conductor. This has the further advantage of that reliable and accurate detection is provided. In addition, the brittle resistors together with the electric resistors being in the plate may give the plate robustness for installation.

According to one aspect of the present disclosure, each electrical brittle conductor is interconnected between two electrical resistors. This configuration allows an even further increase of the resistance for each parallel electrical path. Therefore, in this case and compared to when only one resistor is connected in series, the change in resistance of the electrical circuit or of the current is further increased which even further eases the detection of an impact. In addition, the resistor circuit may have an improved operation balance. This has the further advantage of that reliable and accurate detection is provided.

According to one aspect of the present disclosure, the detection unit is configured to: determine an amount of resistance increase and/or an amount of electrical current drop in response to breaking of at least one of the electrical brittle conductors and determine a severity of the impact on the battery system based on the amount of resistance increase and/or the amount of electrical current drop. That is, the more electrical brittle conductors break, the larger the resistance increase and/or or electrical current drop. Thus, in case the larger the resistance increase and/or or electrical current drop relatively large, a larger amount of brittle conductors have been broken due to the impact. Thus, the amount of resistance increase and/or the amount of electrical current drop carries proportional information on impact severity. This means that the detection unit may determine an impact severity or impact strength for damage assessment depending on the resistance increase and/or or electrical current drop. A warning or a battery disconnect may be provided based on severity.

According to one aspect of the present disclosure, the detection unit may be configured to: determine a number of broken electrical brittle conductors. Since the resistance values may be pre-stored, the resistance increase and/or the electrical current drop can be used by the detection unit, i.e. by the control unit, to determine the number of broken electrical brittle conductors. This information may be used for repairing, i.e. reinstalling and reconfiguring of the resistor circuit after an impact has occurred.

According to one aspect of the present disclosure, each of the plurality of electrical resistors have a same electrical resistance value. This may simplify in an easy manner to determine the number of broken electrical brittle conductors and to evaluate the impact severity. Also, this readily defines a lowest threshold in current drop or resistance increase to be detected.

According to one aspect of the present disclosure, wherein each of the plurality of electrical brittle conductors are aluminum strips. The aluminum strips can be produced to be thin and long and including the brittle feature as well as allowing a conductive property. Thus, aluminum strips are an optimal selection.

According to one aspect of the present disclosure, the electrical resistor circuit is disposed on a surface of the plate member facing the plurality of battery cells. Thus, a deformation of the plate member, i.e., bending by reaching a given bending radius, caused by an impact transfers the deformation directly to the at least one brittle conductor so that the brittle conductor can break. Thus, this configuration is suitable to realize the breaking feature of the electrical brittle conductors. Further, the plate member protects the resistor circuit from environmental damage and facilitates connection.

According to one aspect of the present disclosure, the plate member is separate from the housing and disposed below the housing. Thus, the plate member and the resistor circuit supported thereon can be separately installed. Further, plate member due to the resistors thereon has certain resistance in the installation.

According to one aspect of the present disclosure, the plate member is a bottom plate of the housing. In this case, the impact determined by the detection unit may represent the impact that the components in the battery system are experiencing. Thus, the detection result is representative for the damage caused by the impact on the battery system.

According to one aspect of the present disclosure, the plurality of electrical brittle conductors is spaced from each other and located at predefined locations so that the electrical resistance circuit spans over the plate member and/or the housing. Thus, the detection area is maximized to ensure that any impact on the battery system is detected by the detection unit. Thus, sensitivity was increased.

According to one aspect of the present disclosure, each of the plurality of electrical resistors have a different electrical resistance value, and the detection unit is configured to: determine a position where the impact has occurred based on the amount of resistance increase and/or an amount of electrical current drop. Thus, for each brittle conductor breakage due to the corresponding resistance value, a corresponding resistance increase and/or electrical current drop may occur. The detection unit may thus, based on pre-stored resistance values and pre-stored positions and the detected amount and based on the measurement, identify which among the conductive brittle conductors has been broken to determine a location of the impact. Therefore, a localization feature can be implemented by encoding the electrical resistors with different pre-stored resistance values and pre-stored locations.

According to another aspect of the present disclosure, a method for detect an impact on a battery system, wherein the method includes the steps of: a) providing a battery system including: a plurality of battery cells accommodated in a housing; an impact detection circuit including: an electrical resistor circuit supported by a plate member adjacent the plurality of battery cells including a plurality of electrical brittle conductors electrically connected in parallel to each other, wherein each electrical brittle conductor is configured to break in response to an impact causing a deformation of the electrical brittle conductor. The method further includes to apply, by a voltage source, a voltage to the electrical resistor circuit including the plurality of electrical brittle conductors. The method may further include to determine, by a detection unit, an electrical resistance of the electrical resistor circuit and/or an electrical current flowing through the electrical resistor circuit. The method may further include detecting an impact on the battery system based on determining a resistance increase and/or an electrical current drop due to breaking of at least one of the electrical brittle conductors.

The method has the same advantages as described above in the context of the battery system. The above embodiments of the battery system may as well be implemented in the method. Thus, it is referred to the above parts for the additional details thereof.

According to another aspect, a vehicle including the battery system according to any one of the above embodiments is provided. The battery system may be disposed in an underbody portion of the vehicle. Thus, an impact detection is realized to detect potentially hazardous impacts on the battery system.

### Specific Embodiments

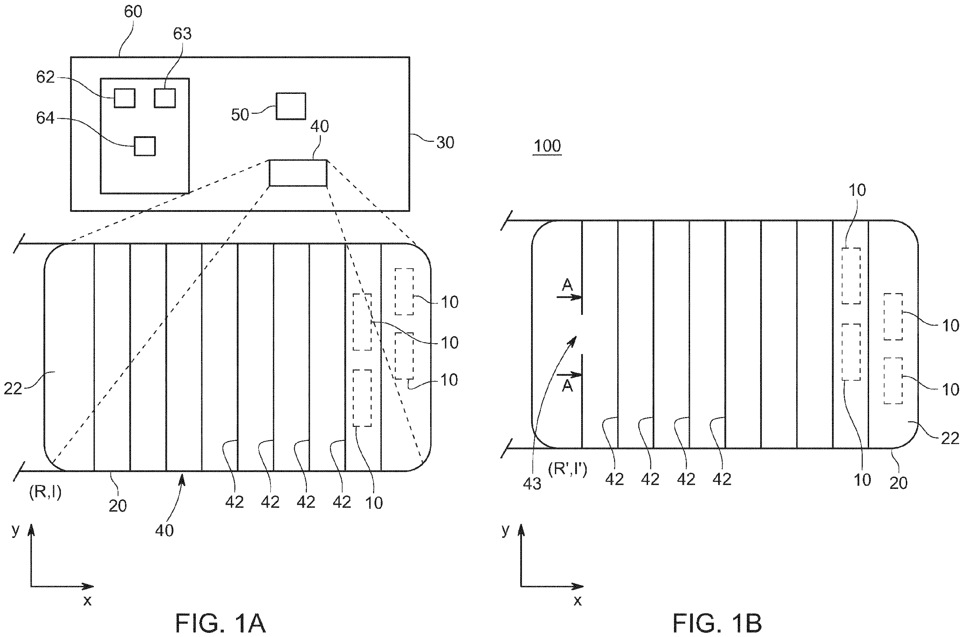

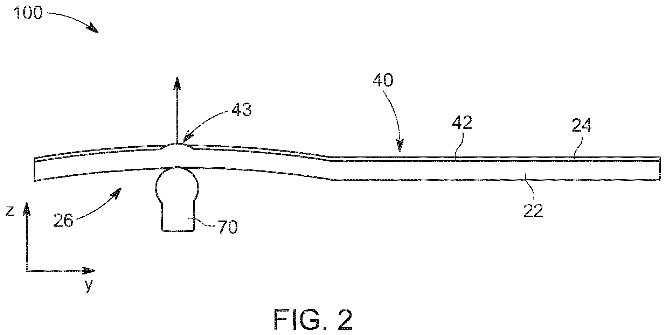

Fig. 1 illustrates a schematic view of a battery system 100. The Fig. 1 includes a schematic representation of parts of the battery system 100 and schematic top view of parts thereof illustrating a state of the battery system 100 in which no impact has occurred (a) and a state of the battery system 100 in which an impact has occurred (b). The impact on the battery system 100 is further illustrated in Fig. 2 referring to a cross section according to section A-A as indicated in Fig. 1 to further illustrate the present application.

The battery system 100 includes a plurality of battery cells 10. The battery cells 10 are here only schematically shown in the top view as a projection.

In the present case, the battery cells 10 are illustrated as being prismatic, but this is merely an example and the battery cells 10 may have different shapes. The plurality of battery cells 10 may be positioned according to a predetermined arrangement and electrically interconnected with each other to provide one or more common outputs.

The battery cells 10 are accommodated in a housing 20. In Fig. 1, only a contour of the housing 20 is provided in an illustrative manner. The housing 20 may protect the battery cells 10 from external impact and can stably support the battery cells 10 at their designated positions.

The battery system 100 includes an impact detection circuit 30. The impact detection circuit 30 is shown schematically in Fig. 1 including several components thereof. The impact detection circuit 30 can detect an impact acting on the battery system 100, for example, acting on the housing 20 of the battery system 100.

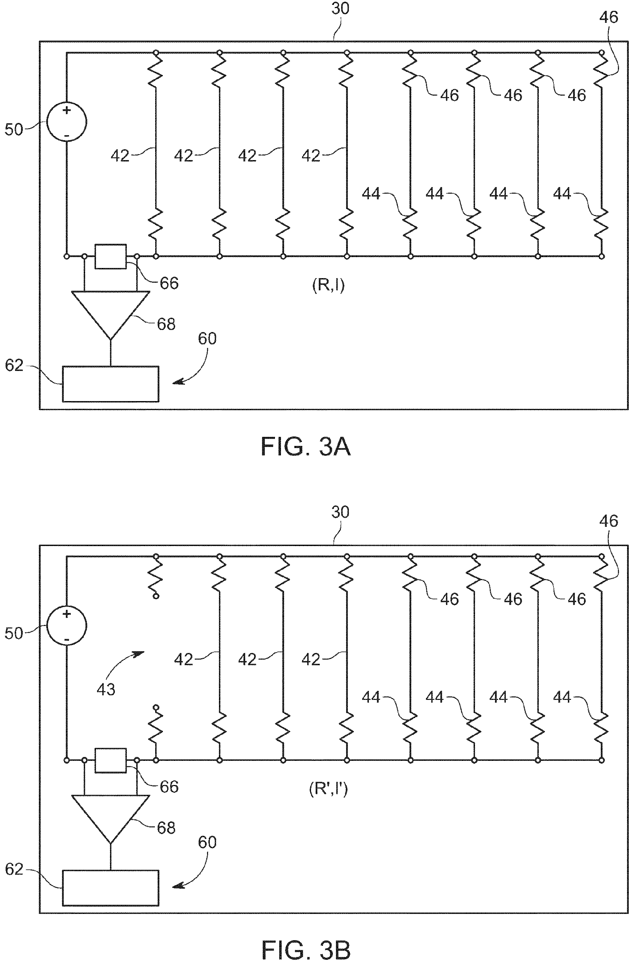

The impact detection circuit 30 includes an electrical resistor circuit 40 as illustrated in Fig. 1. An electrical resistor circuit 40 according to an embodiment is further explained in more detailed in Fig. 3.

The electrical resistor circuit 40 is supported by a plate member 22 as illustrated in the top view of Fig. 1 which simplifies installation. The plate member 22 may be a bottom plate of the housing 20. However, the plate member 22 may also be a separate plate disposed below the housing 20. According to Fig. 2, the electrical resistor circuit 40 may be disposed on the plate member 22. Therefore, an impact affecting the housing 20 may in the same way affect the electrical resistor circuit 40 and thus facilitates braking as used below.

The electrical resistor circuit 40, as shown in Fig. 1, includes a plurality of electrical brittle conductors 42. The electrical brittle conductors 42 are configured to break in response to an impact causing a deformation 26, i.e. when being bend by reaching a given bending radius of the electrical brittle conductor 42. This is illustrated in Fig. 1 (b) by the breaking point 43 at which the electrical brittle conductor 42 broke due to an impact acting on the battery system 100.

Fig. 2 discloses the cross section along the breaking point 43 as indicated in Fig. 1. In this example, the electrical brittle conductor 42 is disposed on a surface 24 of the plate member 22 facing the battery cells 10. The plate member 22 may be a separate member with respect to the housing 20. In other embodiments, the plate member 22 may be the bottom plate of the housing 20. An obstacle 70 below the plate member 22 causes an impact on the battery system 100 resulting in a deformation 26 as illustrated in Fig. 2. The deformation 26 occurs in the plate member 22 and is transferred to the electrical brittle conductor 42 being disposed on the plate member 22. Thus, in result of the impact, the electrical brittle conductor 42 breaks as indicated in Fig. 2. The positioning of the electrical brittle conductor 42 being disposed on the plate member 22 may facilitate the bending and the breaking compared to when being disposed below the plate member 22. Such impact may be caused by various obstacles 70 or various objects. For example, such an obstacle 70 may be a bollard as illustrated in Fig. 2 but the disclosure is not restricted thereto.

Thus, the electrical brittle conductors 42 have a breaking property. That is, each electrical brittle conductor 42 can break in response to an impact acting on the battery system 100 causing a deformation of the electrical brittle conductor 42. When the electrical brittle conductor 42 is sufficiently bent above a deformation threshold, the electrical brittle conductor 42 breaks as illustrated in Fig. 2. Thus, the conductive path through the electrical brittle conductor 42 that is broken becomes non-conductive as illustrated in Fig. 1 (or Fig. 3). Each of the plurality of electrical brittle conductors 42 may be aluminum strips to provide the brittle property while providing thin and long conductors.

The electrical brittle conductors 42 are electrically connected in parallel with each other. Therefore, the plurality of electrical brittle conductors 42 are connected to a common input node and a common output node as is illustrated in Fig. 1.

The impact detection circuit 30 further includes a voltage source 50 as illustrated in the schematic part. The voltage source 50 is a voltage source with a pre-determined voltage output. For example, the voltage output may be 5V or 3.3V, but the invention is not restricted thereto.

The voltage source 50 is connected to the electrical resistor circuit 40. In the above example, the voltage source may be connected to the common output and input nodes of the electrical resistor circuit 40.

Thus, because the voltage source 50 is connected to the electrical resistor circuit 40, the voltage source 50 causes an electrical current I, I' to flow through the electrical resistor circuit 40.

Referring to Fig. 1 (a), the current I is supported by the plurality of parallelly connected electrical brittle conductors 42 in the case without deformation since each of the electrical brittle conductors 42 provide a conductive path. Referring to Fig. 1 (b), the current I' < I is supported by the plurality of parallelly connected electrical brittle conductors 42 in a case of deformation in which at least one electrical brittle conductor 42, here in this example exactly one electrical brittle conductor 42, is broken.

The impact detection circuit 30 further includes a detection unit 60. The detection unit 60 is illustrated in the schematic part of Fig. 1. A more detailed example of a detection unit 60 can be found in Fig. 3.

The detection unit 60 is configured to determine an electrical resistance R, R' of the electrical resistor circuit 40 and/or an electrical current I, I' flowing through the electrical resistor circuit 40. This detection can be provided by various means that allow to determine resistance and/or current.

For example, the detection unit 60 may include at least one sensing unit 64 for the determination of the electrical resistance R, R' of the electrical resistor circuit 40 and/or an electrical current I, I'. Further, a control unit 62 may include at least one processor to process received measurement signals of the electrical resistance R, R' and/or electrical current I, I'. A storage 63 may operatively connected to the control unit 62. The determination of the resistance R, R' may be either indirect through determining/measuring an auxiliary electrical property or may be direct. The sensing unit 64 may be a voltage sensor which measures a voltage drop across a shunt resistor 66 as illustrated in Fig. 3 to determine the resistance R, R' of the electrical resistor circuit 40 and or the electrical current I, I'. The electric current I, I' and or the resistance R, R' are collective properties of the electrical resistor circuit 40. Thus, the resistance R, R' refers to the resistance of the electrical resistor circuit 40 and the electric current I, I' refers to the current that flows through the entire electrical resistor circuit 40.

The detection unit 60 is further configured to detect an impact on the battery system 100. This detection of the impact is performed when the detection unit 60 determines a resistance increase ΔR and/or an electrical current drop ΔI due to breaking of at least one of the electrical brittle conductors 42. That is, the resistance increase ΔR = R - R' and/or the current drop ΔI = I - I' are used to identify an impact on the battery system 100. For example, lower thresholds for current drop ΔI and resistance increase ΔR may be predetermined in order to prevent unwanted detection when no electrical brittle conductor 42 has actually broken.

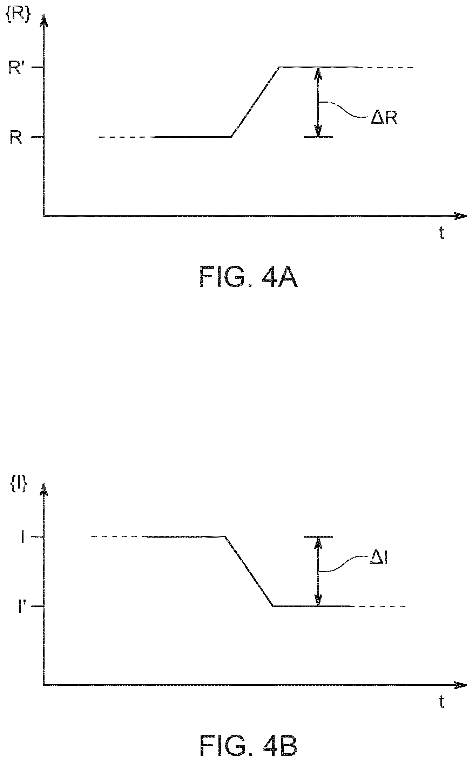

In more detail, when a deformation 26 due to impact has caused an electric brittle conductor 42 to break, the electrical current cannot flow through this broken electrical brittle conductor as indicated in Fig. 1 (b). Thus, the resistance of the electric resistor circuit 40 increases to R'>R. This resistor change ΔR is illustrated in Fig. 4 (a) against a time axis.

At the same time, the supported current through the electric resistor circuit 40 drops to I'<I in response to the breakage of at least one electric brittle conductor 42. This current change ΔI is illustrated in Fig. 4 (b) against a time axis.

Therefore, since it is sufficient according to the present disclosure to detect the collective current I, I' and/or resistance R, R' of the electric resistor circuit 40 compared to a case of monitoring each of the electrical brittle conductors 42 individually thereby requiring less resources while allowing accurate determination of an impact.

Referring to Fig. 1 again, the plurality of electrical brittle conductors 42 are arranged to be spaced from each other and located at predefined locations of the plate member 22 such that the electrical brittle conductors 42 span the plate member 22. The electrical brittle conductors 42 cover an area/size corresponding to the housing 20. Thus, impacts can be detected on the entire area of the housing 20. Since a deformation of the plate member 22 results in a deformation of the electrical brittle conductors 42 a breakage of an electrical brittle conductor 42 can occur and detected at the various positions of the plate member 22.

Referring to Fig. 3 of the present disclosure, an impact detection circuit 30 according to an embodiment is shown. For the features in common Fig. 1, it is referred to the above disclosure. Fig. 3 illustrates a state of the battery system 100 in which no impact has occurred (a), i.e. a healthy state, and a state of the battery system 100 in which an impact has occurred (b).

In this preferred embodiment, the electrical resistor circuit 40 further includes a plurality of electrical resistors 44, 46. Here each of the electrical brittle conductors 42 is electrically connected in series with at least one electrical resistor 44, 46. The electrical brittle conductors 42 usually have a very small resistance value. Thus, in case of electrical brittle conductor breakage, the resistance difference ΔR = R - R' and/or the current drop ΔI = I - I' are small. Therefore, detection of an impact by the detection unit 60 may be difficult or at least requires complex detection equipment and resolution.

Therefore, according to the present disclosure, at least one electrical resistor 44, 46 is connected in series with the electrical brittle conductors 42. The resistance value of the at least one electrical resistor 44, 46 may be substantially higher than the resistance value of the at least one electrical resistor 44, 46. Thus in case of breakage of at least one electrical brittle conductor 42 due to an impact, no current can flow through the corresponding at least one electrical resistor 44, 46. This results in a higher resistance difference ΔR = R - R' and/or current drop ΔI = I - I' compared to the case where no electrical resistor 44, 46 are used. In consequence, the at least one resistor 44, 46 eases the signal detection of an impact for the detection unit 60. Thus, a more reliable detection may be achieved.

As an example shown in Fig. 3, the detection unit 60 may include a control unit 62. The control unit 62 may include processing capability to process received measurement signals of the electrical resistance R, R' and/or electrical current I, I'. Further, a sensing unit 64 may be provided to measure the directly or indirectly the resistance and current. For an example, a shunt resistor 66 may be used together with an amplifier 68 as illustrated in Fig. 3 but the invention is not restricted thereto. Thus, when using the at least one electrical resistor 44, 46 in series with the electrical brittle conductors 42, not much requirements on the amplifier 68 are needed compared to a case where no at least one electrical resistor 44, 46 is included. For example, the amplifier 68 may even be omitted in case of when the at least one electrical resistor 44, 46 is used.

In an embodiment as illustrated in Fig. 3, each electrical brittle conductor 42 is interconnected between two electrical resistors 44, 46. Thus, this configuration allows to further increase the resistance difference ΔR = R - R' and/or the current drop ΔI = I - I' in case of breakage of at least one electrical brittle conductor 42 which eases the detection of an impact by the detection unit 60 such that an even more reliable detection may be reached.

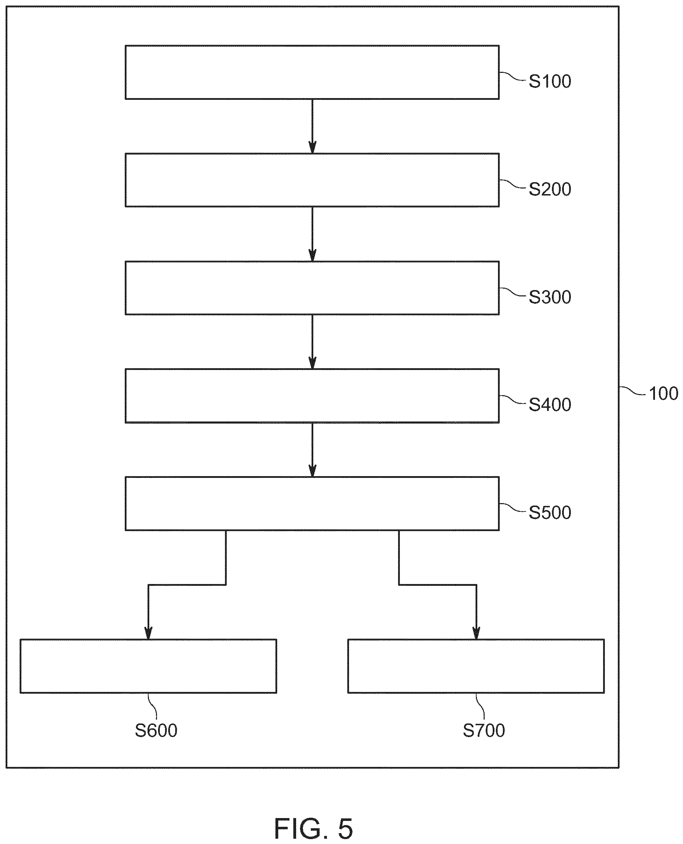

The disclosure further allows various ways of evaluating the impact occurred. For example, more particular information on the impact on the battery system 100 may be extracted for further diagnosis of the impact. This will be explained in the following and is also referenced to the method as illustrated in Fig. 5.

The detection unit 60 may determine an amount of resistance increase ΔR and/or an amount of electrical current drop ΔI in response to breaking of at least one of the electrical brittle conductors 42. For example, as illustrated in Fig. 4, the current drop ΔI due to breakage of one electrical brittle conductor 42 may have value of 2.5 µA which is detected by the detection unit 60. The detection unit 60 may then determine a severity of the impact on the battery system 100 based on the amount of resistance increase ΔR and/or based on the amount of electrical current drop ΔI.

Therefore, since an impact with higher severity may cause more electrical brittle conductors 42 to break, this results in a higher resistance increase ΔR and/or a higher amount of electrical current drop ΔI. Therefore, the amount of resistance increase ΔR and/or the amount of electrical current drop ΔI can be used to evaluate the impact severity. This detection is also shown in step S400 of Fig. 5.

Further, the detection unit 60 may determine a number of broken electrical brittle conductors 42 based on the mount of resistance increase ΔR and/or on the amount of electrical current drop ΔI. For example, when each of the plurality of electrical resistors 44 have the same electrical resistance value, the detection unit 60, via the control unit 62, may be able to determine a number of broken electrical brittle conductors 42. For example, the control unit 62 may use the pre-stored resistor values. The pre-stored values may be provided in the storage 63. The determined number of broken electrical brittle conductors 42 may be needed for repairing the impact detector circuit 30 after the impact has occurred. This detection may also be found in step S600.

In a further embodiment, each of the plurality of electrical resistors 44 may have a different electrical resistance value distinguishable from the other resistors among the plurality of resistors 44. In this case, the detection unit 60 may be configured to determine a location on the plate member 22 where the impact has occurred based on the amount of resistance increase ΔR and/or an amount of electrical current drop ΔI. In more detail, the detection unit 60, via the control unit 62, may access pre-stored resistance values of the electrical resistors 44 and pre-stored positions. The pre-stored values may be provided in the storage 63. Thus, the detection unit 60 may identify from the determined amount of resistance increase ΔR and/or an amount of electrical current drop ΔI the electrical resistors corresponding to the broken brittle conductor. Thus, location may be determined based on the pre-stored location. The location information may be used to estimate which of the battery components may be affected by the impact. This detection may also be found in step S700.

Fig. 5 illustrates a method of detecting an impact on the battery system 100. The steps can be performed by the battery system 100 as disclosed above. Thus, for further details omitted in this section, it is referred to the above disclosure.

The method discloses the step of providing S100 a battery system 100 including a plurality of battery cells 10 accommodated in a housing 20. The electrical resistor circuit 40 supported by a plate member 22 adjacent the plurality of battery cells 10. For example, the electrical resistor circuit 40 extends in plane below the battery cells 10. The electrical resistor circuit 40 may be as wide as the housing 20. That is, the electrical resistor circuit 40 may be disposed on the plate member 22 or integrated therein. The electrical resistor circuit 40 includes a plurality of electrical brittle conductors 42 electrically connected in parallel to each other, wherein each electrical brittle conductor 42 is configured to break in response to an impact causing a deformation of the electrical brittle conductor 42. For further structural features, it is referred to the above description with respect to Figs. 1 to 4.

The method includes the step of applying, by a voltage source 50, a voltage S200 to the electrical resistor circuit 40. This causes a current to flow through the electrical resistor circuit 40 as described above.

The method further includes the step of determining S300, by a detection unit 60, an electrical resistance R, R' of the electrical resistor circuit 40 and/or an electrical current I, I' flowing through the electrical resistor circuit 40. The method further includes the step of detecting S400, by the detection unit 60, an impact on the battery system 100 when determining a resistance increase ΔR and/or an electrical current drop ΔI due to breaking of at least one of the electrical brittle conductors 42. Thus, with only one detection unit, an impact can be accurately detected.

In addition, as already referred to above, the method may include determine S500 an amount of resistance increase ΔR and/or an amount of electrical current drop ΔI in response to breaking of at least one of the electrical brittle conductors 42 to determine a severity of the impact on the battery system 100 based on the amount of resistance increase ΔR and/or an amount of electrical current drop ΔI. It is referred to the above description for further details thereof.

Further, the method may include the step of determining a number S600 of broken electrical brittle conductors 42 based on the amount of resistance increase ΔR and/or an amount of electrical current drop ΔI. In this embodiment, the resistors may have the same resistance values. It is referred to the above description for further details thereof.

Further, the method may include to determine S700 a location on the plate member 22 where the impact has occurred based on the amount of resistance increase ΔR and/or an amount of electrical current drop ΔI. In this embodiment, the resistors may have the same resistance values. It is referred to the above description for further details thereof.

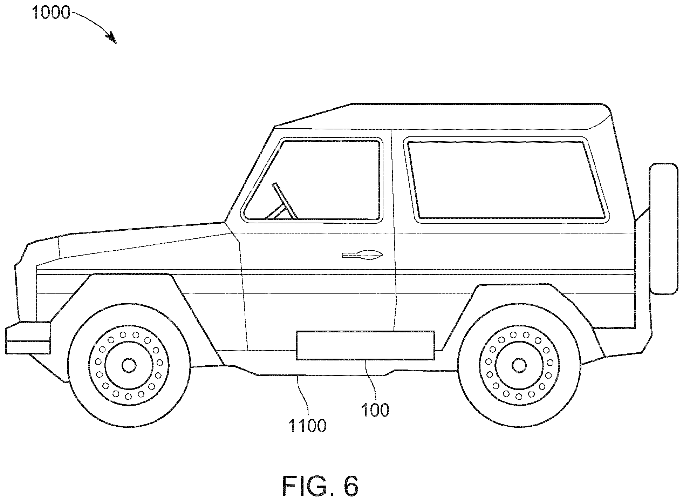

Fig. 6 of the present disclosure shows a vehicle 1000 including the battery system 100 according to any of the above embodiments. The battery system 100 may be positioned in an underbody portion 1100 of the vehicle. The battery system 100 may have an accurate and resource-saving impact detection that can be easily integrated.

In summary, a battery system 100 is provided which allows to accurately detect an impact by using electrical brittle conductors 42 in an electrical resistor circuit 40 which break due to an impact. The detection requires reduced resources and includes features to improved detection strength. Various detection information can be easily used as described above.

### Reference signs

- 10: battery cell

- 20: housing
- 22: plate member
- 24: surface
- 26: deformation

- 30: impact detection circuit

- 40: electrical resistor circuit
- 42: electrical brittle conductor
- 43: break point
- 44: resistor
- 46: resistor

- 50: voltage source

- 60: detection unit
- 62: control unit
- 63: storage
- 64: sensing unit
- 66: shunt resistor
- 68: amplifier

- 70: obstacle

- 100: battery system

- 1000: vehicle
- 1100: underbody portion

- S100: providing battery system
- S200: apply voltage
- S300: determine electrical resistor R, R' and current I, I'
- S400: determine an impact
- S500: determine impact severity
- S600: determine number of broken brittle conductors
- S700: determine location

## Claims

1. A battery system (100), comprising:
a plurality of battery cells (10) accommodated in a housing (20); and
an impact detection circuit (30), comprising:
an electrical resistor circuit (40) supported by a plate member (22) adjacent the plurality of battery cells (10) and comprising a plurality of electrical brittle conductors (42) electrically connected in parallel to each other, wherein each electrical brittle conductor (42) is configured to break in response to an impact causing a deformation of the electrical brittle conductor (42);
a voltage source (50) connected to the electrical resistor circuit (40) and configured to apply a voltage to the electrical resistor circuit (40); and
a detection unit (60) configured to:
determine an electrical resistance (R, R') of the electrical resistor circuit (40) and/or an electrical current (I, I') flowing through the electrical resistor circuit (40), and
detect an impact on the battery system (100) based on determining a resistance increase (ΔR) and/or an electrical current drop (ΔI) due to breaking of at least one of the electrical brittle conductors (42).

2. The battery system (100) according to claim 1, wherein the electrical resistor circuit (40) further comprises a plurality of electrical resistors (44, 46), wherein each electrical brittle conductor (42) is electrically connected in series with at least one electrical resistor (44).

3. The battery system (100) according to claim 2, wherein each electrical brittle conductor (42) is interconnected between two electrical resistors (44, 46).

4. The battery system (100) according to any one of the preceding claims 1 to 3, wherein the detection unit (60) is configured to:
determining an amount of resistance increase (ΔR) and/or an amount of electrical current drop (ΔI) in response to breaking of at least one of the electrical brittle conductors (42); and
determine a severity of the impact on the battery system (100) based on the mount of resistance increase (ΔR) and/or an amount of electrical current drop (ΔI).

5. The battery system (100) according to claim 4, wherein the detection unit (60) is configured to:
determine a number of broken electrical brittle conductors (42) based on the mount of resistance increase (ΔR) and/or an amount of electrical current drop (ΔI).

6. The battery system (100) according to any one of the preceding claims 1 to 5, wherein each of the plurality of electrical resistors (44, 46) have a same electrical resistance value.

7. The battery system (100) according to any one of the preceding claims 1 to 6, wherein each of the plurality of electrical brittle conductors (42) are aluminum strips.

8. The battery system (100) according to any one of the preceding claims 1 to 7, wherein the electrical resistor circuit (40) is disposed on a surface (24) of the plate member (22) facing the plurality of battery cells (10).

9. The battery system (100) according to any one of the preceding claims 1 to 7, wherein the plate member (22) is separate from the housing (20) and disposed below the housing (20).

10. The battery system (100) according to claims 8 and 9, wherein the plate member (22) is a bottom plate of the housing (20).

11. The battery system (100) according to any one of the preceding claims 8 to 10, wherein the plurality of electrical brittle conductors (42) is spaced from each other and located at predefined locations so that the electrical resistor circuit (40) spans over the plate member (22).

12. The battery system (100) according to claim 11, wherein each of the plurality of electrical resistors (44) have a different electrical resistance value, and
the detection unit (60) is configured to:
determining an amount of resistance increase (ΔR) and/or an amount of electrical current drop (ΔI) in response to breaking of at least one of the electrical brittle conductors (42); and
determine a location on the plate member (22) where the impact has occurred based on the amount of resistance increase (ΔR) and/or an amount of electrical current drop (ΔI).

13. A method for detecting an impact on a battery system (100), wherein the method comprises the steps of:
a) providing (S100) a battery system (100) comprising:
a plurality of battery cells (10) accommodated in a housing (20);
an electrical resistor circuit (40) at the housing (20), the electrical resistor circuit (40) comprising a plurality of electrical brittle conductors (42) electrically connected in parallel to each other, wherein each electrical brittle conductor (42) is configured to break in response to an impact causing a deformation of the electrical brittle conductor (42);
b) apply (S200), by a voltage source (50), a voltage to the electrical resistor circuit (40); and
c) determine (S300), by a detection unit (60), an electrical resistance (R, R') of the electrical resistor circuit (40) and/or an electrical current (I, I') flowing through the electrical resistor circuit (40), and
d) detect (S400), by the detection unit (60) an impact on the battery system (100) based on determining a resistance increase (ΔR) and/or an electrical current drop (ΔI) due to breaking of at least one of the electrical brittle conductors (42).

14. A vehicle (1000) comprising the battery system (100) according to any one of the preceding claims 1 to 12.

15. The vehicle (1000) of claim 14, wherein the battery system (100) is positioned in an underbody portion (1100) of the vehicle (1000).
